# EUROPEAN PATENT APPLICATION

(11) **EP 1 724 926 A1**
(43) Date of publication of application: **22.11.2006**
(21) Application number: 05710704.7
(22) Date of filing: 25.02.2005
(51) Int. Cl.: H03L 7/087, H03L 7/113, G11B 20/14, H04L 7/033

(54) **PHASE LOCK CIRCUIT AND INFORMATION REPRODUCTION DEVICE**

(30) Priority: 04.03.2004 JP 2004061234
(71) Applicant: SONY CORPORATION, Tokyo 141-0001 (JP)
(72) Inventor: SENBA, Kimimasa, SONY CORPORATION, Tokyo 1410001 (JP)
(74) Representative: Müller - Hoffmann & Partner
(86) International application number: PCT/JP2005/003154
(87) International publication number: WO 2005/086352

(57) **Abstract**

A PLL circuit and an information reproduction apparatus able to reduce an influence of erroneous detection even when erroneous detection of a frequency comparator occurs and able to realize stable and high speed frequency lock-in, having a frequency comparator 25 fetching a zero cross signal ZC in synchronization with clocks CLKA to CLKC from a VCO 23 and observing from which phase to which phase an edge of the zero cross changed in synchronization with the clock CLKA and thereby detecting high/low of the frequency as frequency error and outputting an up signal UP or a down signal DOWN, an integration circuit 26 integrating the signal UP or DOWN, a comparator 27 receiving the integrated up signal UP or down signal DOWN, judging a direction of the frequency error, and outputting three signals of UPM, DOWNM, and NONM, and a gain adjustment circuit 28 determining whether or not the signal is to be output or determining a feedback gain from the pattern of a sequence of the signals UPM, DOWNM, and NONM, and outputting the same.

## Description

### TECHNICAL FIELD

The present invention relates to a phase locked loop (PLL) circuit applied to an RF signal processing system of for example an optical disc device and an information reproduction apparatus provided with the same.

### BACKGROUND ART

In general, in an RF signal processing system of a digital recording/reproducing apparatus for an optical disc etc., use is made of a PLL circuit obtaining suitable clocks by comparing phases and frequencies for recording and reproducing data.

As a method for comparing frequencies in a PLL circuit for an optical disc, use is made of for example a method of extracting a wobble signal on the disc and locking to this frequency to thereby synchronize with a rotation speed of the disc.
However, this method cannot be used in for example a case of a disc in which no wobble signal exists (as one example, a Blu-Ray Disc ROM, hereinafter referred to as a "BDROM")

Also, a method not using a wobble signal, but extracting a frame synchronization signal periodically recorded for each recording frame and locking to this signal is used (see for example Patent Document 1).

Further, as a method for extracting a frequency error from among random data patterns, a method of monitoring multi-phase clocks of a voltage controlled oscillator (VCO) standard or phase transition of a data edge based on multi-phase clocks is known (see for example Patent Document 2).
Patent Document 1: Japanese Patent Publication (A) No. 11-232795
Patent Document 2: Japanese Patent Publication (A) No. 11-308097

### DISCLOSURE OF THE INVENTION

### PROBLEM TO BE SOLVED BY THE INVENTION

In the case of the method disclosed in Patent Document 1, however, a phase frequency comparison cycle depends upon a frame cycle and becomes long (1932T cycle in the case of a BDROM), therefore there is the disadvantage that a long time is taken for lock-in when including also a time up to detection of frame synchronization, so this method is not suitable for high speed frequency lock-in.

Further, in the method disclosed in Patent Document 2, when it is applied to a high density optical disc, due to the influence of equalization error of an analog signal, perturbation of the disc, noise, etc., the quality of an input data edge is poor, therefore there is the disadvantage that erroneous detection by the frequency detector frequently occurs, so stable frequency lock-in is not possible.
Further, in this method, the frequency detection gain is not proportional to the frequency error and the gain is lowered when the error becomes large to a certain extent, therefore there is the possibility that such erroneous detection in a state where an initial frequency error is large will increase the lock-in time or the frequency may end up being scattered to outside of the lock-in range.
Further, the frequency error must be within the phase lock-in range at the time of switching to a phase mode, but when the convergence value is not stabilized due to the erroneous detection of a frequency loop, there is a possibility that phase lock-in is not possible and the data can no longer be read.
The loop gain may be lowered in order to secure the stability of the frequency loop, but the time taken for the lock-in increases in that case.

An object of the present invention is to provide a PLL circuit and an information reproduction apparatus able to reduce the influence of erroneous detection even in the case where erroneous detection of a frequency comparator occurs and able to realize stable and high speed frequency lock-in.

### MEANS FOR SOLVING THE PROBLEM

A phase locked loop circuit according to a first aspect of the present invention has an oscillation circuit oscillating with a frequency in accordance with a control signal and outputting a clock having a predetermined frequency; a phase comparison circuit detecting a phase difference between a clock from the oscillation circuit and an input signal and outputting phase difference data; a feedback circuit generating the control signal based on the phase difference data of the phase comparison circuit and a feedback signal and supplying the same to the oscillation circuit; a frequency comparator comparing frequencies of the input signal and the clock of the oscillation circuit and outputting a signal in accordance with a frequency error; an integration circuit integrating the signal in accordance with the frequency error of the frequency comparator; a judgment circuit judging a direction of the frequency error from the integration result of the integration circuit; and a gain adjustment circuit switching a feedback gain of the feedback signal based on the judgment result of the judgment circuit.

Preferably, the gain adjustment circuit switches the feedback gain of the feedback signal based on a sequential pattern of judgment results of the judgment circuit.

Preferably, an integration constant of the integration circuit is adjustable.

Preferably, the judgment circuit performs the judgment based on a predetermined threshold value and, when the judgment result is smaller than the threshold value, outputs a signal for suspending the output of the feedback signal to the gain adjustment circuit.
More preferably, the judgment threshold value of the judgment circuit is adjustable.

Preferably, the gain adjustment circuit does not output the feedback signal in an initial lock-in state and, when continuously receiving as input the same judgment result, sequentially increases the feedback gain.
More preferably, the gain adjustment circuit once makes the feedback gain zero when receiving as input a judgment result of detection of frequency error in a reverse direction due to erroneous detection in the middle of lock-in, then sequentially increases the feedback gain when continuously receiving as input the same judgment result.

A phase locked loop circuit of a second aspect of the present invention has an oscillation circuit oscillating with a frequency in accordance with a control signal and outputting multi-phase clocks having different phases from each other; a phase comparison circuit detecting a phase difference between one clock among the multi-phase clocks from the oscillation circuit and an input signal and outputting phase difference data; a feedback circuit generating the control signal based on the phase difference data of the phase comparison circuit and a feedback signal and supplying the same to the oscillation circuit; a frequency comparator detecting frequency error between the input signal and the clock from a zero cross edge of the input signal based on a zero cross signal of the input signal and the multi-phase clocks of the oscillation circuit and outputting a signal in accordance with the frequency error; an integration circuit integrating the signal in accordance with the frequency error of the frequency comparator; a judgment circuit for judging the direction of the frequency error from the integration result of the integration circuit; and a gain adjustment circuit for switching the feedback gain of the feedback signal based on the judgment result of the judgment circuit.

Preferably, the frequency comparator fetches the zero cross signal of the input signal based on the multi-phase clocks of the oscillation circuit and observes from which phase to which phase the edge of the zero cross of the input data signal changed in synchronization with the one clock among the multi-phase clocks to thereby detect whether the frequency is high or low as the frequency error.

More preferably, the frequency comparator suspends the output of the signal in accordance with the frequency error when the change of the edge of the zero cross is detected at a timing when it does not occur in a case of normal operation.

A third aspect of the present invention provides an information reproduction apparatus for sampling a signal read from a recording medium based on a clock to convert it to a digital signal for reproduction, the apparatus having a phase locked loop circuit for making a sampling phase by the clock match with a correct state, wherein the phase locked loop circuit has: an oscillation circuit oscillating with a frequency in accordance with a control signal and outputting a clock having a predetermined frequency, a phase comparison circuit detecting a phase difference between a clock from the oscillation circuit and an input signal and outputting phase difference data, a feedback circuit generating the control signal based on the phase difference data of the phase comparison circuit and a feedback signal and supplying the same to the oscillation circuit, a frequency comparator comparing frequencies of the input signal and the clock of the oscillation circuit and outputting a signal in accordance with a frequency error, an integration circuit integrating the signal in accordance with the frequency error of the frequency comparator, a judgment circuit judging a direction of the frequency error from the integration result of the integration circuit, and a gain adjustment circuit switching a feedback gain of the feedback signal based on the judgment result of the judgment circuit.

A fourth aspect of the present invention provides an information reproduction circuit for sampling a sine wave state signal read from a recording medium based on clocks to convert it to a digital signal for reproduction, the apparatus having a phase locked loop circuit for making a sampling phase from the clock match with a correct state, wherein the phase locked loop circuit has an oscillation circuit oscillating with a frequency in accordance with a control signal and outputting multi-phase clocks having different phases from each other, a phase comparison circuit detecting a phase difference between one clock among the multi-phase clocks from the oscillation circuit and an input signal and outputting phase difference data, a feedback circuit generating the control signal based on the phase difference data of the phase comparison circuit and a feedback signal and supplying the same to the oscillation circuit, a frequency comparator detecting a frequency error between the input clock and the clock from a zero cross edge of the input signal based on a zero cross signal of the input signal and the multi-phase clocks of the oscillation circuit and outputting a signal in accordance with the frequency error, an integration circuit integrating the signal in accordance with the frequency error of the frequency comparator, a judgment circuit judging the direction of the frequency error from the integration result of the integration circuit, and a gain adjustment circuit switching the feedback gain of the feedback signal based on the judgment result of the judgment circuit.

According to the present invention, clocks of the oscillation circuit are supplied to the phase comparison circuit and the frequency comparator.
First, in the frequency comparator, frequencies of the input signal and the clock of the oscillation circuit are compared, and a signal in accordance with the frequency error is output to the integration circuit.
The integration circuit integrates the signal in accordance with the frequency error of the frequency comparator and supplies it to the judgment circuit. The judgment circuit judges the direction of the frequency error from the integration results of the integration circuit and switches the feedback gain of the feedback signal based on the judgment results of the judgment circuit.
Further, the phase comparison circuit detects the phase difference of a clock from the oscillation circuit and the input signal and outputs the phase difference data to the feedback circuit.
The control signal is generated based on the phase difference data of the phase comparison circuit and the feedback signal, and the oscillation frequency of the oscillation circuit is controlled.

### EFFECTS OF THE INVENTION

According to the present invention, even when the quality of for example the zero cross edge of the input signal is bad and erroneous detection of the frequency comparator occurs, the influence thereof can be reduced and, as a result, stable and high speed frequency lock-in becomes possible.
Further, even in a frequency detection method other than the above, for example, a frequency comparison system directly measuring a zero cross interval of the data, there are the advantages that the influence of erroneous detection is reduced and stable and high speed frequency lock-in becomes possible.

### BRIEF DESCRIPTION OF THE DRAWINGS

[FIG. 1] FIG. 1 is a diagram of the system configuration showing an embodiment of an RF signal processing system of an optical disc device employing a PLL circuit according to the present embodiment.
[FIG. 2] FIG. 2A to FIG. 2Z are timing charts showing waveforms of an input data signal, a zero cross signal, three phase clocks, and portions of a frequency comparator in the PLL circuit according to the present embodiment.
[FIG. 3] FIG. 3 is a diagram showing an image of operation of the frequency comparator according to the present embodiment.
[FIG. 4] FIG. 4 is a diagram showing comparison logic of the frequency comparator according to the present embodiment.
[FIG. 5] FIG. 5 is a circuit diagram showing an example of a logic circuit of the frequency comparator enabling a detection operation of FIG. 3.
[FIG. 6] FIG. 6 is a graph showing an example of a waveform after equalization of read data in a high density optical disc.
[FIG. 7] FIG. 7 is a graph showing an example of distribution of data zero cross timings in a high density optical disc.
[FIG. 8] FIG. 8 is a diagram showing an output characteristic (detection gain) of the frequency comparator.
[FIG. 9] FIG. 9A to FIG. 9H are timing charts showing operations of an integrator and a comparator using counters and showing an example of operation in a case where a signal UPM is output from the comparator when an integration setting is 8 and a judgment threshold value is 4.
[FIG. 10] FIG. 10A to FIG. 10H are timing charts showing operations of an integrator and a comparator using counters and showing an example of operation in a case where a signal NONM is output from the comparator when the integration setting value is 8 and the judgment threshold value is 4.
[FIG. 11] FIG. 11 is a diagram showing the logic of pattern detection and a gain adjustment circuit according to the present embodiment.
[FIG. 12] FIG. 12A to FIG. 12F are timing charts showing the operation in an initial frequency lock-in state of the pattern detection and gain adjustment circuit.
[FIG. 13] FIG. 13A to FIG. 13F are timing charts showing the operation in the middle of frequency lock-in of the pattern detection and gain adjustment circuit.
[FIG. 14] FIG. 14A to FIG. 14F are timing charts showing the operation at a time of convergence of the pattern detection and gain adjustment circuit.

### DESCRIPTION OF NOTATIONS

10... optical disc device, 11... optical disc, 12... optical head, 13... pre-amplifier, 14... AGC circuit, 15... analog equalizer, 16... analog/digital converter (ADC), 17... FIR filter, 18... viterbi decoder, 19... decoder (ECC, interface (I/F), 20... encoder, 21... laser driver, 22... phase comparator, 23... VCO, 24... zero cross comparator, 25... frequency comparator, 26... integration circuit, 27... comparator serving as judgment circuit, 28... pattern detection and gain adjustment circuit, 29... charge pump circuit, 30... loop filter, 40... PLL circuit.

### BEST MODE FOR WORKING THE INVENTION

Below, embodiment of the present invention will be explained with reference to the attached drawings.

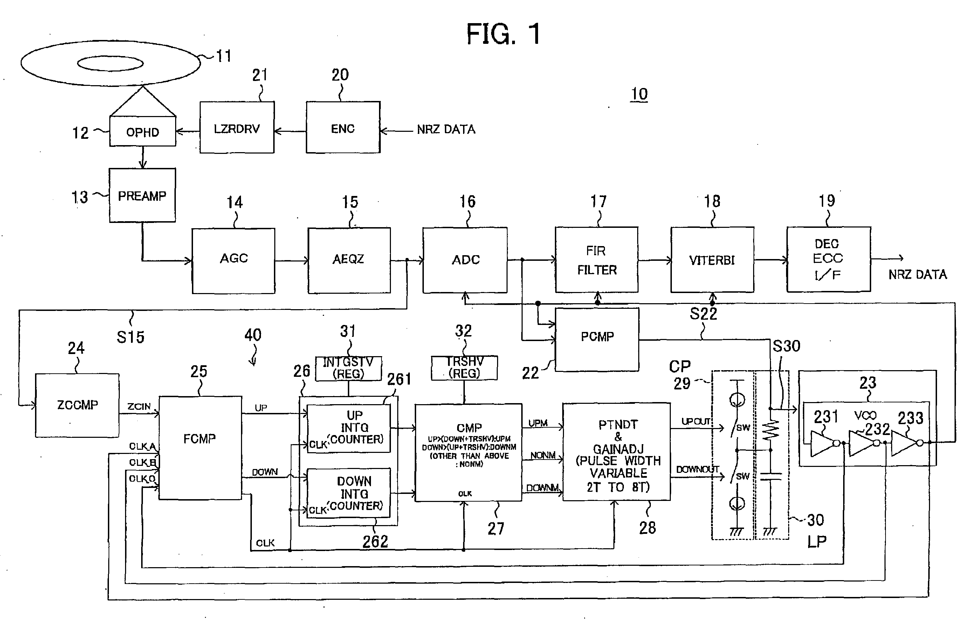

FIG. 1 is a diagram of the system configuration showing an embodiment of an RF signal processing system of an optical disc device employing a PLL circuit (phase locked loop circuit) according to the present embodiment.

The present optical disc device 10, as shown in FIG. 1, has an optical disc 11 serving as the recording medium, an optical head (OPHD) 12, a pre-amplifier (PREAMP) 13, an AGC (auto gain control) circuit 14, an analog equalizer (AEQZ) 15, an analog/digital converter (ADC) 16, a FIR filter 17, a viterbi decoder (VITERBI) 18, a decoder (DEC, ECC, interface (I/F)) 19, an encoder (ENC) 20, a laser driver (LZRDRV) 21, a phase comparator (PCMP) 22, a VCO 23, a zero cross comparator (ZCCMP) 24, a frequency comparator (FCMP) 25, an integration circuit 26, a comparator (CMP) 27 serving as the judgment circuit, a pattern detection (PTNDT) and gain adjustment circuit (GAINADJ) 28, a charge pump circuit (CP) 29, and a loop filter (LP) 30.

Among these components, the phase comparator 22, VCO 23, zero cross comparator 24, frequency comparator 25, integration circuit 26, comparator 27 serving as the judgment circuit, pattern detection and gain adjustment circuit 28, charge pump circuit 29, and loop filter 30 configure a PLL circuit 40 of the present invention. The charge pump circuit 29 and the loop filter 30 configure the feedback circuit of the present invention.
Below, the explanation will be given centered on the specific functions of the components of this PLL circuit.

In the optical disc device 10, a reproduction signal output from the optical disc head 12 and amplified at the pre-amplifier 13 is adjusted in amplitude in the AGC circuit 14 and input to the analog equalizer circuit 15.
The reproduction signal equalized by the analog equalizer 15 and eliminated high frequency noise is input to the ADC 16 and the zero cross comparator 24.
The output of the ADC 16 is input to the phase comparator 22 of the PLL circuit. As will be explained later, the PLL circuit 40 controls the VCO 23 to match the sampling phase of the ADC 16.
Further, the output of the ADC 16 is input to the FIR filter 17, further equalized with a high precision, then input to the viterbi decoder 18, decoded and corrected for error, then output as NRZ (non-return-to-zero) data.
Further, the NRZ data is encoded at the encoder 20. The laser of the optical head 12 is controlled in drive by the laser driver 21 based on this result.

Below, the PLL circuit will be explained in more detail.

The phase comparator 22 compares the phase of the digital signal from the ADC 16 and the phase of the output clock CLKA of the VCO 23 and outputs phase error data S22 to the loop filter 30.

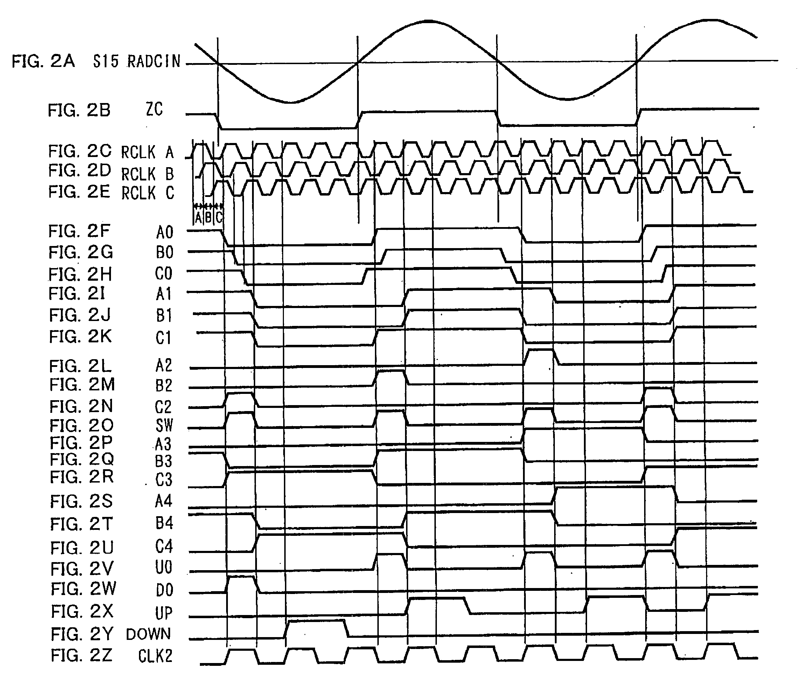

The VCO 23 has a 3-stage ring configuration of inverters 231 to 233. The oscillation frequency is controlled by a control signal S30 obtained by integrating the phase error data S22 by the loop filter 30.
In the VCO 23, the outputs from the different stages of the 3-stage ring configuration become the three phase clocks CLKA, CLKB, and CLKC dividing one cycle of CLK to 3 as shown in FIG. 2C, FIG. 2D, and FIG. 2E. These three phase clocks CLKA, CLKB, and CLKC are supplied to the frequency comparator 25.
A first phase clock of the VCO 23 (output clock of the inverter 233) is supplied to the ADC 16, the FIR filter 17, the viterbi decoder 18, and the phase comparator 22.

The zero cross comparator 24 receives a sine wave state RF reproduction signal S15 as shown in for example FIG. 2A from the analog equalizer 15 and outputs a zero cross signal ZC as shown in FIG. 2B having a level changing corresponding to the zero cross point to the frequency comparator 25.

The PLL circuit needs to make the sampling phase of the ADC 16 match with the correct state, but when the deviation between the input signal frequency and the clock frequency is large (when it exceeds for example approximately 3%), phase lock-in by the phase detector is difficult, therefore, first, it is necessary to pull in the frequency deviation by the frequency loop.
The frequency comparator 25 is arranged in a first stage of this frequency loop.

The frequency comparator 25 fetches the zero cross signal ZC from the zero cross comparator 24 in synchronization with the three phase clocks CLKA, CLKB, and CLKC from the VCO 23 and thereafter in synchronization with for example the first phase clock CLKA, observes from which phase to which phase the edge of the zero cross of the input data signal changed to thereby detect whether the frequency is high or low as the frequency error and outputs an up signal UP or a down signal DOWN to the integration circuit 26.

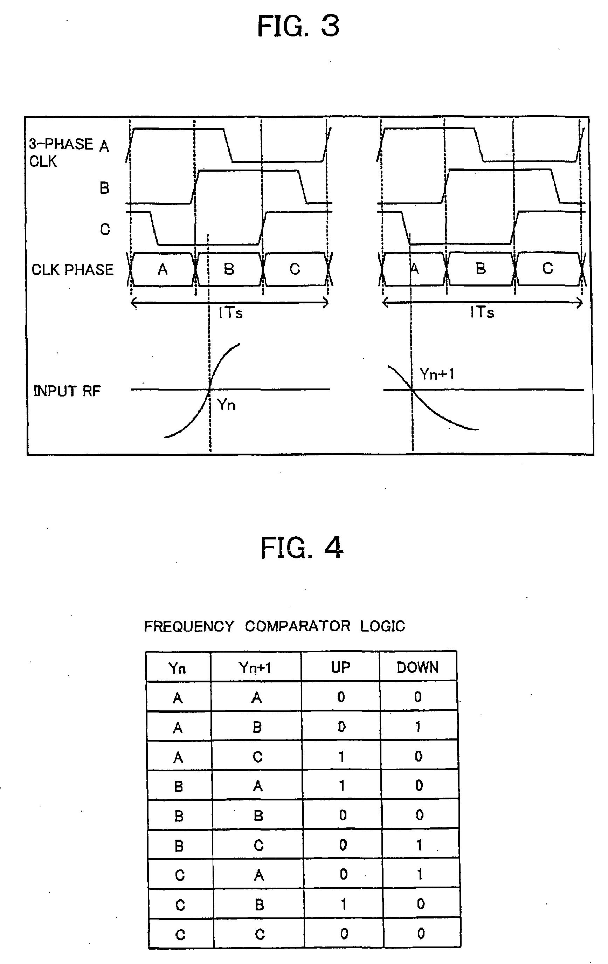

FIG. 3 is a diagram showing an image of the operation of the frequency comparator according to the present embodiment. Further, FIG. 4 is a diagram showing a comparison logic of the frequency comparator according to the present embodiment.

As shown in FIG. 3, the three phase clocks of the first phase clock CLKA, the second phase clock CLKB, and the third phase clock CLKC divide 1 clock CLK section into three. The phase sections are defined as A, B, and C.
At this time, the (direction of) frequency error is detected as follows from transition of phases of the present edge Yn and a next edge Yn+1 of the zero cross of the input data signal.

When the transition of the edge is the forward direction (A → B → C) with respect to the phases A, B, and C in the clock CLK1 cycle, it can be considered that the input signal frequency is lower than the oscillation frequency of the VCO 23, therefore a down signal DOWN is output.
When the transition of the edge is a reverse direction (C → B → A), it is considered that the frequency of the input data signal is higher than the oscillation frequency of the VCO 23, therefore an up signal UP is output.
When there is no phase transition of the edge, error detection is not possible, therefore nothing is output.

Specifically, as shown in FIG. 4, the frequency comparator 25 cannot detect error since there is no phase transition of the edge when the edge Yn has the phase A and the next edge Yn+1 has the phase A, therefore neither the up signal UP nor the down signal DOWN is output.
In a case where the edge Yn has the phase A and the next edge Yn+1 has the phase B, it is considered that the frequency of the input data signal is lower than the oscillation frequency of the VCO 23, therefore the down signal DOWN is output.
In a case where the edge Yn has the phase A and the next edge Yn+1 has the phase C, it is considered that the frequency of the input data signal is higher than the oscillation frequency, therefore the up signal UP is output.
In a case where the edge Yn has the phase B and the next edge Yn+1 has the phase A, it is considered that the frequency of the input data signal is higher than the oscillation frequency, therefore the up signal UP is output.
In a case where the edge Yn has the phase B and the next edge Yn+1 has the phase B, there is no phase transition of the edge and the error detection is not possible, therefore neither the up signal UP nor the down signal DOWN is output.
In a case where the edge Yn has the phase B and the next edge Yn+1 has the phase C, it is considered that the frequency of the input data signal is lower than the oscillation frequency of the VCO 23, therefore the down signal DOWN is output.
In a case where the edge Yn has the phase C and the next edge Yn+1 has the phase A, it is considered that the frequency of the input data signal is lower than the oscillation frequency, therefore the down signal DOWN is output.
In a case where the edge Yn has the phase C and the next edge Yn+1 has the phase B, it is considered that the frequency of the input data signal is higher than the oscillation frequency, therefore the up signal UP is output.
In a case where the edge Yn has the phase C and the next edge Yn+1 has the phase C, there is no phase transition of the edge and the error detection is not possible, therefore neither the up signal UP nor the down signal DOWN is output.

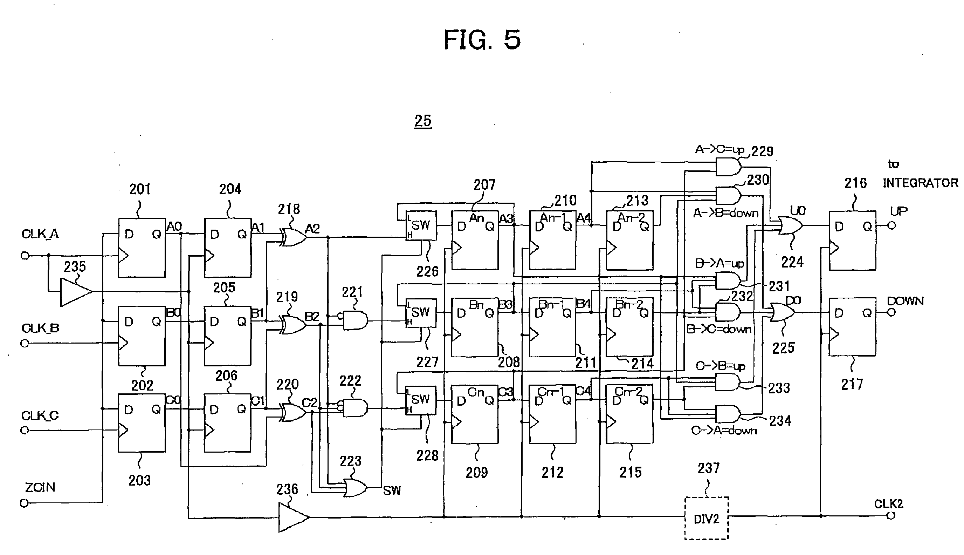

FIG. 5 is a circuit diagram showing an example of the logic circuit of the frequency comparator enabling the detection operation of FIG. 3.

The frequency comparator 25 of FIG. 5 has D-type flip-flops 201 to 217, exclusive logical OR (EXOR) gates 218 to 220, a 2-input AND gate 221 including a negative input, a 3-input AND gate 222 including the negative input, 3-input OR gates 223 to 225, switch circuits 226 to 228, a 2-input AND gate 229, 3-input AND gates 230 to 234, and buffers 235 and 236 for delaying etc. the first phase clock CLKA.

The flip-flops 201 to 203 are arranged in parallel with respect to the input ZCIN of the zero cross signal ZC. The flip-flop 201 latches the zero cross signal ZC in synchronization with the first phase clock CLKA, the flip-flop 202 latches the zero cross signal ZC in synchronization with the second phase clock CLKB, and the flip-flop 203 latches the zero cross signal ZC in synchronization with the third phase clock CLKC.
Namely, the flip-flops 201 to 203 are arranged at the input stage of the frequency comparator 25 and latch the zero cross signal ZC from the zero cross comparator 24 in synchronization with the three phase clocks CLKA, CLKB, and CLKC of the VCO 23.
FIG. 2F to FIG. 2H show Q-outputs of the flip-flops 201 to 203 as A0, B0, and C0.
Note that, the first and subsequent stage flip-flops 204 to 217 input/output data in synchronization with the first phase clock CLKA.

The D-input of the flip-flop 204 is connected to the Q-output of the first stage flip-flop 201, the D-input of the flip-flop 205 is connected to the Q-output of the first stage flip-flop 202, and the D-input of the flip-flop 206 is connected to the Q-output of the first stage flip-flop 203.
The flip-flops 204 to 206 latch the outputs of the flip-flops 201 to 203 in synchronization with the first phase clock CLKA via the buffer 235.
FIG. 2I to FIG. 2K show Q-outputs of the flip-flops 204 to 206 as A1, B1, and C1.

The EXOR 218 takes the exclusive logical OR between the output A1 of the flip-flop 204 and the output B1 of the flip-flop 205 and supplies the result to the H-input of the switch 226, the negative input of the AND gate 221, the first negative input of the AND gate 222, and the first input of the OR gate 223.
The EXOR 219 takes the exclusive logical OR between the output B1 of the flip-flop 205 and the output C1 of the flip-flop 206 and supplies the result to the positive input of the AND gate 221, the second negative input of the AND gate 222, and the second input of the OR gate 223.
The EXOR 220 takes the exclusive logical OR between the output C1 of the flip-flop 206 and the output A0 of the first stage flip-flop 201 and outputs the result to the positive input of the AND gate 222 and the third input of the OR gate 223.
These three EXORs 218 to 220 are provided in order to obtain the current (present) clock. Each extract one of the clocks CLKA, CLKB, and CLKC.
FIG. 2L to FIG. 2N show outputs of the EXORs 218 to 220 as A2, B2, and C2.
One of the outputs A2, B2, and C2 of the EXORs 218 to 220 becomes the high level when there is a zero cross. In this example, the output C2 of the EXOR 220 becomes the high level.

The output of the AND gate 221 is supplied to the H-input of the switch circuit 227, and the output of the AND gate 222 is supplied to the H-input of the switch circuit 228.
The OR gate 223 takes the logical OR of the outputs A2, B2, and C2 of the EXORs 218 to 220 and outputs the same as the switch signal SW to the switch circuits 226 to 228.

The switch circuits 226 to 228 select the H-input by considering that the zero cross point is detected in the case where the switch signal SW is at the high level and outputs the same to D-inputs of the corresponding flip-flops 207 to 209 in the next stage.
The switch circuits 226 to 228 select the L-input considering that the zero cross point is not detected in the case where the switch signal SW is at the low level and form a loop for inputting the Q-outputs of the corresponding flip-flops 207 to 209 in the next stage to the D-inputs.
FIG. 20 shows the switch signal SW as the output of the OR gate 223.

The flip-flops 207 to 209 fetch outputs of the corresponding switch circuits 226 to 228 in synchronization with the first phase clock CLKA via the buffers 235 and 226 as explained above.
The flip-flops 207 to 209 continuously latch the data latched the previous time by the loop formed by the switch circuits 226 to 228 in synchronization with the first phase clock CLKA during a period where the zero cross is not detected and, where the zero cross is detected, latch the data at the point of time of detection through the switch circuits 226 to 228 in synchronization with the first phase clock CLKA.
The Q-output of the flip-flop 207 is supplied to the L-input of the switch circuit 226, the D-input of the next stage flip-flop 210, the first input of the AND gate 231, and the third input of the AND gate 234.
The Q-output of the flip-flop 208 is supplied to the L-input of the switch circuit 227, the D-input of the next stage flip-flop 211, the third input of the AND gate 230, and the second input of the AND gate 233.
The Q-output of the flip-flop 209 is supplied to the L-input of the switch circuit 228, the D-input of the next stage flip-flop 212, the second input of the AND gate 229, and the third input of the AND gate 232.
FIG. 2P to FIG. 2R show Q-outputs of the flip-flops 207 to 209 as A3, B3, and C3.

The flip-flops 210 to 212 latch outputs of the flip-flops 207 to 209 in synchronization with the first phase clock CLKA via the buffers 235 and 236.
The output of the flip-flop 210 is supplied to the D-input of the next stage flip-flop 213, the first input of the AND gate 229, and the first input of the AND gate 230.
The output of the flip-flop 211 is supplied to the D-input of the next stage flip-flop 214, the second input of the AND gate 231, and the first input of the AND gate 232.
The output of the flip-flop 212 is supplied to the D-input of the next stage flip-flop 215, the first input of the AND gate 233, and the second input of the AND gate 234.
FIG. 2S to FIG. 2U show Q-outputs of the flip-flops 210 to 212 as A4, B4, and C4.

The flip-flops 213 to 215 latch outputs of the flip-flops 210 to 212 in synchronization with the first phase clock CLKA via the buffers 235 and 236.
The Q-output of the flip-flop 213 is supplied to the second input of the AND gate 230.
The Q-output of the flip-flop 214 is supplied to the third input of the AND gate 231 and the second input of the AND gate 232.
The output of the flip-flop 215 is supplied to the third input of the AND gate 233 and the first input of the AND gate 234.

The AND gate 229 supplies a signal of the high level to the first input of the OR gate 224 so as to output the up signal UP by considering that the frequency of the input data signal is higher than the oscillation frequency of the VCO 23 when the edge Yn has the phase A and the next edge Yn+1 has the phase C based on the logic of FIG. 4
The AND gate 230 supplies a signal of the high level to the first input of the OR gate 225 so as to output the down signal DOWN by considering that the frequency of the input data signal is lower than the oscillation frequency of the VCO 23 when the previous edge Yn has the phase A and the next edge Yn+1 has the phase B based on the logic of FIG. 4
The AND gates 229 and 230 supply signals of the low level to the gates 224 and 225 so as to output neither the up signal UP nor the down signal DOWN since there is no phase transition of the edge and the error detection is not possible when the edge Yn has the phase A and the edge Yn+1 has the phase A.

The AND gate 231 supplies a signal of the high level to the second input of the OR gate 224 so as to output the up signal UP by considering that the frequency of the input data signal is higher than the oscillation frequency of the VCO 23 when the previous edge Yn has the phase B and the next edge Yn+1 has the phase A based on the logic of FIG. 4
The AND gate 232 supplies a signal of the high level to the second input of the OR gate 225 so as to output the down signal DOWN by considering that the frequency of the input data signal is lower than the oscillation frequency of the VCO 23 when the previous edge Yn has the phase B and the next edge Yn+1 has the phase C based on the logic of FIG. 4
The AND gates 231 and 232 supply signals of the low level to the gates 224 and 225 so as to output neither the up signal UP nor the down signal DOWN since there is no phase transition of the edge and the error detection is not possible when the edge Yn has the phase B and the edge Yn+1 has the phase B.

The AND gate 233 supplies a signal of the high level to the third input of the OR gate 224 so as to output the up signal UP by considering that the frequency of the input data signal is higher than the oscillation frequency of the VCO 23 when the previous edge Yn has the phase C and the next edge Yn+1 has the phase B based on the logic of FIG. 4
The AND gate 234 supplies a signal of the high level to the third input of the OR gate 225 so as to output the down signal DOWN by considering that the frequency of the input data signal is lower than the oscillation frequency of the VCO 23 when the previous edge Yn has the phase C and the next edge Yn+1 has the phase A based on the logic of FIG. 4
The AND gates 233 and 234 supply signals of the low level to the gates 224 and 225 so as to output neither the up signal UP nor the down signal DOWN since there is no phase transition of the edge and the error detection is not possible when the edge Yn has the phase C and the edge Yn+1 has the phase C.

The OR gate 224 takes the logical OR of output signals of the AND gates 229, 231 and 233 and supplies the same to the D-input of the flip-flop 216 of the output stage of the up signal UP.
The OR gate 225 takes the logical OR of output signals of the AND gates 230, 232 and 234 and supplies the same to the D-input of the flip-flop 217 of the output stage of the down signal DOWN.
FIG. 2V and FIG. 2W show outputs of the OR gates 224 and 225 as U0 and D0.

The flip-flop 216 latches the output U0 taking the high level or low level of the OR gate 234 in synchronization with the first phase clock CLKA via the buffers 235 and 236 and outputs the up signal UP to the integration circuit 26 from the Q-output.
The flip-flop 217 latches the output D0 taking the high level or low level of the OR gate 235 in synchronization with the first phase clock CLKA via the buffers 235 and 236 and outputs the down signal DOWN to the integration circuit 26 from the Q-output.
FIG. 2X and FIG. 2Y show the up signal UP and the down signal DOWN as outputs of the flip-flops 216 and 217.

Note that it is also possible to configure a system so that a frequency divider (for example 2-division) 237 is provided as indicated by a broken line in FIG. 5. The first phase clock CLKA supplied to the flip-flops 216 and 217 is defined as the first phase clock CLK2 after the frequency division, and the up signal UP and the down signal DOWN are latched and output.
FIG. 2Z shows this clock CLK2.
The first phase clock CLKA via the buffers 235 and 236 or the further divided clock CLK2 is supplied as the operation clock of the integrators (INTG) 261 and 262 of the integration circuit 26, the comparator 27, and the pattern detection and gain adjustment circuit 28 as shown in FIG. 1.

Note that, in the frequency comparator 25 of FIG. 5, data indicating at which phase the previous zero cross was detected is set in the flip-flops 210 to 212, and data indicating at which phase the present (next) zero cross was detected is set in the flip-flops 207 to 209, therefore the information of the detected phase of the previous edge Yn and the information of the detected phase of the next edge Yn+1 is obtained, so it is not always necessary to provide flip-flops 213 to 215 in order to detect the phase change.
In the present embodiment, the flip-flops 213 to 215 are provided for the following reason.

These are provided in order not to output the up signal UP and the down signal DOWN but to ignore them by considering that data based on noise etc. was fetched if there is a change in the detected phase in 1T since detection of two zero crosses in one cycle of the first phase clock CLKA is impossible in the characteristics of the data.

For example, in the case of normal operation, when the previous edge Yn has the phase A and the next edge Yn+1 has the phase B, the output A4 of the flip-flop 210 and the output B3 of the flip-flop 208 must be at the high level and the output of the flip-flop 213 latching the data before the present data by 1T must be at the high level, therefore, in the AND gate 230, considering that the frequency of the input data signal is lower than the oscillation frequency of the VCO 23, a signal of the high level is supplied to the OR gate 225 in order to output the down signal DOWN.
However, due to noise etc., when there is a change in the detected phase in 1T, the output of the flip-flop 213 is at the low level, therefore the output of the AND gate 230 is masked and held at the low level, and the output of the down signal DOWN is suppressed.

In the same way, in the case of normal operation, when the previous edge Yn has the phase B, and the next edge Yn+1 has the phase A, the output A3 of the flip-flop 207 and the output B4 of the flip-flop 211 must be at the high level and also the output of the flip-flop 214 latching the data before the present data by 1T must be at the high level, therefore, in the AND gate 231, considering that the frequency of the input data signal is higher than the oscillation frequency of the VCO 23, the signal of the high level is supplied to the OR gate 224 in order to output the up signal UP.
However, due to the noise etc., when there is a change in the detected phase in 1T, the output of the flip-flop 214 is at the low level, therefore the output of the AND gate 231 is masked and held at the low level, and the output of the up signal UP is suppressed.

In the same way, in the case of normal operation, when the previous edge Yn has the phase B, and the next edge Yn+1 has the phase C, the output C3 of the flip-flop 209 and the output B4 of the flip-flop 211 must be the high level and also the output of the flip-flop 214 latching the data before the present data by 1T must be at the high level, therefore, in the AND gate 232, considering that the frequency of the input data signal is lower than the oscillation frequency of the VCO 23, a signal of the high level is supplied to the OR gate 225 in order to output the down signal DOWN.
However, the output of the flip-flop 214 is at the low level when there is a change in the detected phase in 1T due to noise etc., therefore the output of the AND gate 232 is masked and held at the low level, and the output of the down signal DOWN is suppressed.

In the same way, in the case of normal operation, when the previous edge Yn has the phase C and the next edge Yn+1 has the phase B, the output B3 of the flip-flop 208 and the output C4 of the flip-flop 212 must be the high level and also the output of the flip-flop 215 latching the data before the present data by 1T must be at the high level, therefore, in the AND gate 233, considering that the frequency of the input data signal is higher than the oscillation frequency of the VCO 23, a signal of the high level is supplied to the OR gate 224 in order to output the up signal UP.
However, the output of the flip-flop 215 is at the low level when there is a change in the detected phase in 1T due to noise etc., therefore the output of the AND gate 233 is masked and held at the low level, and the output of the up signal UP is suppressed.

In the same way, in the case of normal operation, when the previous edge Yn has the phase C and the next edge Yn+1 has the phase A, the output A3 of the flip-flop 207 and the output C4 of the flip-flop 212 must be the high level and also the output of the flip-flop 215 latching the data before the present data by 1T must be at the high level, therefore, in the AND gate 234, considering that the frequency of the input data signal is lower than the oscillation frequency of the VCO 23, a signal of the high level is supplied to the OR gate 225 in order to output the down signal DOWN.
However, the output of the flip-flop 215 is at the low level when there is a change in the detected phase in 1T due to the noise etc., therefore the output of the AND gate 234 is masked and held at the low level, and the output of the down signal DOWN is suppressed.

Note that when the frequency comparison method of the frequency comparator 25 explained above is used in random data patterns recorded with a high density, the deterioration of the quality of the timing of the data edge due to various factors results in the correct frequency not being detected in some cases. As the factors for the deterioration of quality, there are the following factors.
· Deterioration due to tilt (radially or tangentially);
· Deterioration due to focus deviation;
· Asymmetry (non-linear distortion) due to light power deviation;
· Deterioration due to spherical surface aberration; and
· Equalization error depending upon the frequency characteristic of the equalizer.

Further, when partial response equalization is carried out, frequency detection from the zero cross edge cannot always be carried out, but in the case of a BDROM, by a combination of channel codes (1-7RLL) and PR2 (1-2-1), the zero cross information can be used for the frequency detection.
In this combination, however, the data level after the equalization takes the four values of ±1 and ±2, therefore, the amplitude of a short cycle pattern (2T) becomes small with respect to an envelope of the data, therefore the inclination of the zero cross edge becomes lower which becomes a factor of deterioration of the timing quality due to the circuit offset and noise and other factors.

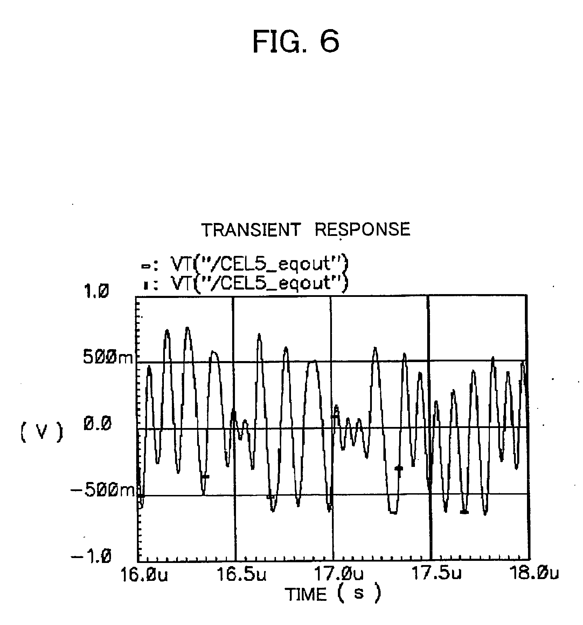

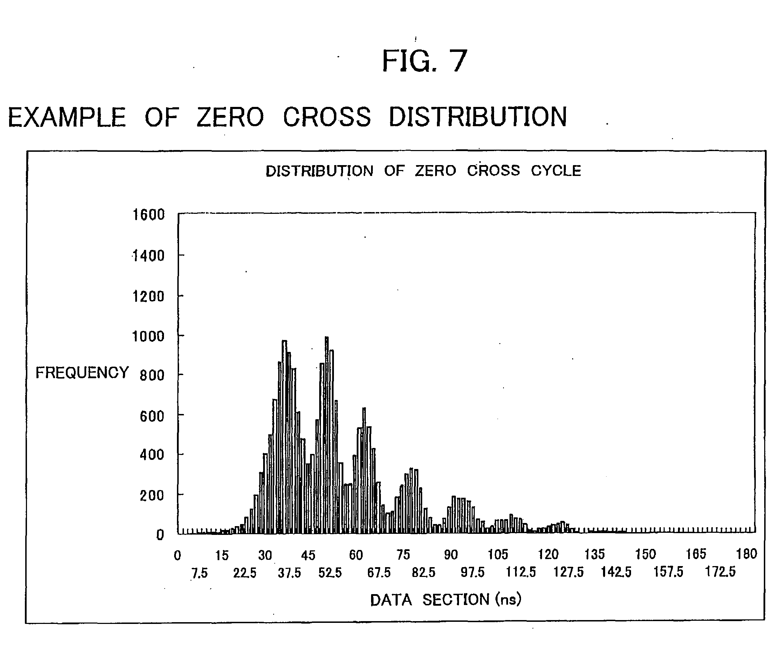

FIG. 6 is a diagram showing an example of the waveform after equalization in the case of a BDROM.
Further, FIG. 7 is a diagram showing an example of distribution of zero cross edges in the case of the deterioration due to the above factors.
In FIG. 7, the peaks in the distribution are patterns of 2T to 8T.
As seen also from this data, a ratio of 2T per unit time is the largest. It is considered that the influence of the signal quality of this edge exerted upon the precision of the frequency detection is large.
The spread of the distribution of each pattern has a width of ±1T or more, therefore the pattern are not sufficiently separated and erroneous detection frequently occurs for this reason.
Due to the above factor, it is necessary to lock in the frequency at a high speed even in the case where erroneous detection of the frequency detector occurs.

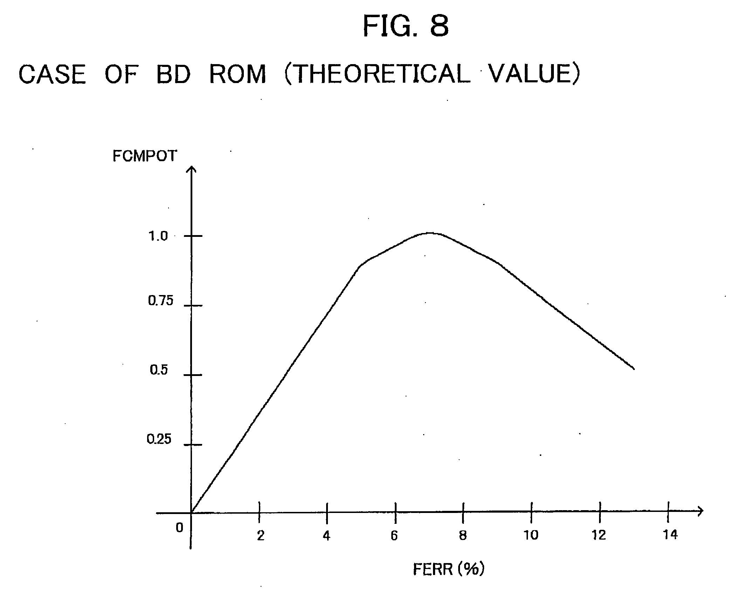

FIG. 8 is a diagram showing the output characteristic of the frequency comparator. In FIG. 8, an abscissa indicates the frequency error (FERR), and an ordinate indicates the output of the frequency comparator (FCMPOT).
In the frequency detection according to this method, respect to the frequency error, but becomes a convex curve which peaks near the frequency error of 7%. The gain is lowered when the frequency error increases.
It is necessary to prevent such reduction of the gain and realize stable high speed lock-in regardless of the frequency error.

For this reason, first, as shown also in FIG. 1, the up signal UP and the down signal DOWN of the outputs of the frequency detector 25 are integrated in the integration circuit 26.

The integration circuit 26 has for example an UP integrator 261 and a DOWN integrator 262 configured by for example counters, integrates the up signal UP or the down signal DOWN of the frequency comparator 25 based on an integration setting value INTSTV set in a register (REG) 31, and outputs the same to the comparator 27.

Note that, in the present embodiment, a counter is used as the integrator for simplification of the circuit, but another unit may be used so far as it functions as an integrator. An LPF (Low Pass Filter) or the like may be used.

The comparator 27 receives the up signal UP or down signal DOWN integrated by the integration circuit 26, judges the direction of the frequency error in accordance with the judgment threshold value (TRSHV) set in the register (REG) 32, and outputs three signals of UPM, DOWNM, and NONM to the pattern detection and gain adjustment circuit 28 in accordance with the judgment result.

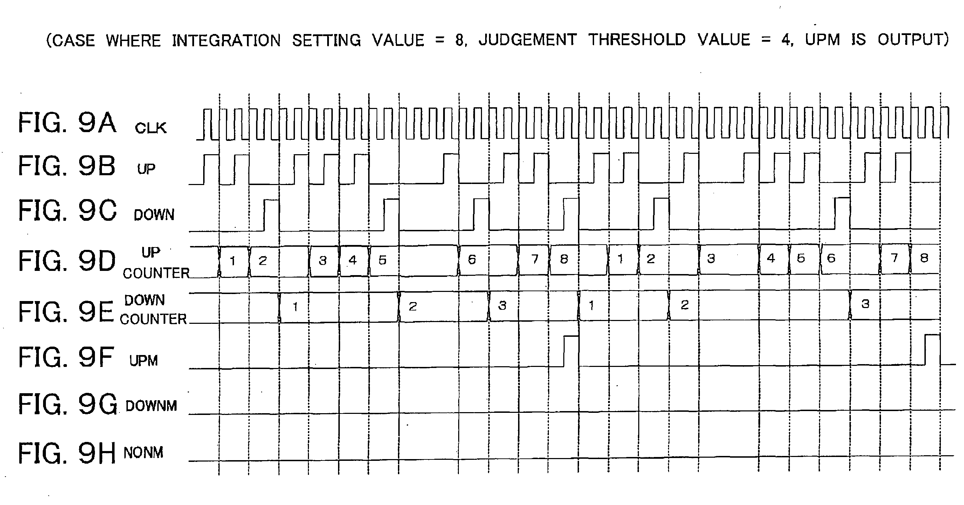

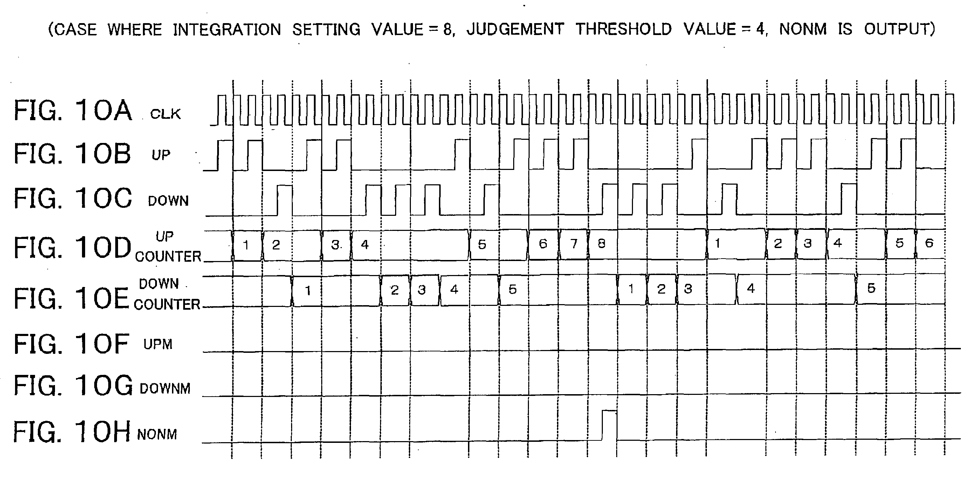

FIG. 9A to FIG. 9H and FIG. 10A to FIG. 10H are timing charts showing operations of the integrator and the comparator using counters, and FIG. 9A to FIG. 9H show operations in the case where the signal UPM is output from the comparator 27 when the integration setting value INTGSTV is 8 and the judgment threshold value TRSHV is 4. FIG. 10A to FIG. 10H show operations in the case where the signal NONM is output from the comparator 27 when the integration setting value INTGSTV is 8 and the judgment threshold value TRSHV is 4.
Note that, in the case of the counter, at the point of time when the count of the up signal UP or the down signal DOWN reaches the setting value, the count value is compared at the comparator, the signal UPM or DOWNM is output, and the counter is reset.

FIG. 9A to FIG. 9H show the case where the signal UPM is output, but the same operation is carried out also for the signal DOWNM.
In this example, the UP counter 261 of the integration circuit 26 counts 8, and the DOWN counter 262 counts 3. Then, a difference 5 between the two counts is larger than the judgment threshold value 4, therefore the signal UPM is output.
Further, the comparator 27 has a threshold setting function and outputs a signal NONM when the difference of the counts is smaller than the threshold value 4, therefore a comparison result having a low reliability can be masked.

FIG. 10A to FIG. 10H show the case where the signal NONM is output.
In this example, the UP counter 261 of the integration circuit 26 counts 8, and the DOWN counter 262 counts 5. The difference 3 between the two count values is smaller than the judgment threshold value 4, therefore the signal NON is output. A comparison result having a low reliability is masked.

There is a case where local error detection depending upon the writing pattern etc. cannot be prevented by only these functions, therefore the influence of the local error detection is prevented without increasing the integration value in the following way.
The three error signals of UPM, DOWNM, and NONM from the comparator 27 are input to the pattern detection and gain adjustment circuit 28.

The pattern detection and gain adjustment circuit 28 outputs the signal UPOUT or DOWNOUT to the charge pump circuit 29 from the sequence of the three signals UPM, DOWNM, and NONM from the comparator 27, outputs nothing, or changes the width of the output pulse in accordance with the pattern.

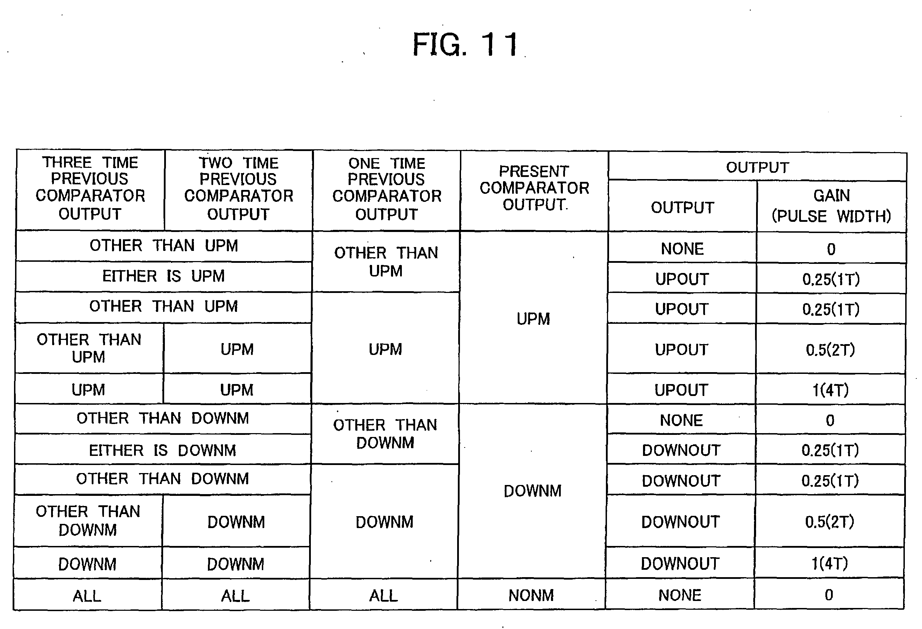

FIG. 11 is a diagram showing the logic of the pattern detection and gain adjustment circuit 28.
In this example, the three time previous output, the two time previous output, and the one time previous output of the comparator 27 and the present output of the comparator 27 are sequentially viewed to determine the output and feedback gain (pulse width).

In a case where the three time previous output, the two time previous output, and the one time previous output of the comparator 27 are other than UPM, and the present output of the comparator 27 is UPM, the pattern detection and gain adjustment circuit 28 outputs nothing, and the gain is set at 0.
In a case where either of the three time previous output or the two time previous output of the comparator 27 is UPM, the one time previous output is other than UPM, and the present output of the comparator 27 is UPM, the pattern detection and gain adjustment circuit 28 outputs the signal UPOUT, and the gain is set at 0.25 (1T).
In a case where both of the three time previous output and two time previous output of the comparator 27 are other than UPM, the one time previous output is UPM, and the present output of the comparator 27 is UPM, the pattern detection and gain adjustment circuit 28 outputs the signal UPOUT, and the gain is set at 0.25 (1T).
In a case where the three time previous output of the comparator 27 is other then UPM, the two time previous output is UPM, the one time previous output is UPM, and the present output of the comparator 27 is UPM, the pattern detection and gain adjustment circuit 28 outputs the signal UPOUT, and the gain is set at 0.5 (2T).
In a case where the three time previous output, the two time previous output, the one time previous output of the comparator 27, and the present output of the comparator 27 are all UPM, the pattern detection and gain adjustment circuit 28 outputs the signal UPOUT, and the gain is set at 1 (4T).

In a case where the three time previous output, the two time previous output, and the one time previous output of the comparator 27 are other than DOWNM, and the present output of the comparator 27 is DOWNM, the pattern detection and gain adjustment circuit 28 outputs nothing, and the gain is set at 0.
In a case where either of the three time previous output or the two time previous output of the comparator 27 is DOWNM, the one previous output is other than DOWNM, and the present output of the comparator 27 is DOWNM, the pattern detection and gain adjustment circuit 28 outputs the signal DOWNOUT, and the gain is set at 0.25 (1T).
In a case where both of the three time previous output and the two time previous output of the comparator 27 are other than DOWNM, the one time previous output is DOWNM, and the present output of the comparator 27 is DOWNM, the pattern detection and gain adjustment circuit 28 outputs the signal DOWNOUT, and the gain is set at 0.25 (1T).
In a case where the three time previous output of the comparator 27 is other than DOWNM, all of two time previous outputs are DOWNM, the one time previous output is DOWNM, and the present output of the comparator 27 is DOWNM, the pattern detection and gain adjustment circuit 28 outputs the signal DOWNOUT, and the gain is set at 0.5 (2T).
In a case where all of the three time previous output, the two time previous output, the one time previous output of the comparator 27, and the present output of the comparator 27 are DOWNM, the pattern detection and gain adjustment circuit 28 outputs the DOWNOUT, and the gain is set at 1 (4T).

Further, in a case where the three time previous output, the two time previous output, and the one time previous output of the comparator 27 are either of UPM, other than UPM, DOWNM, or other than DOWNM, and all of the present outputs of the comparator 27 are NONM, the pattern detection and gain adjustment circuit 28 outputs nothing, and the gain is set at 0.

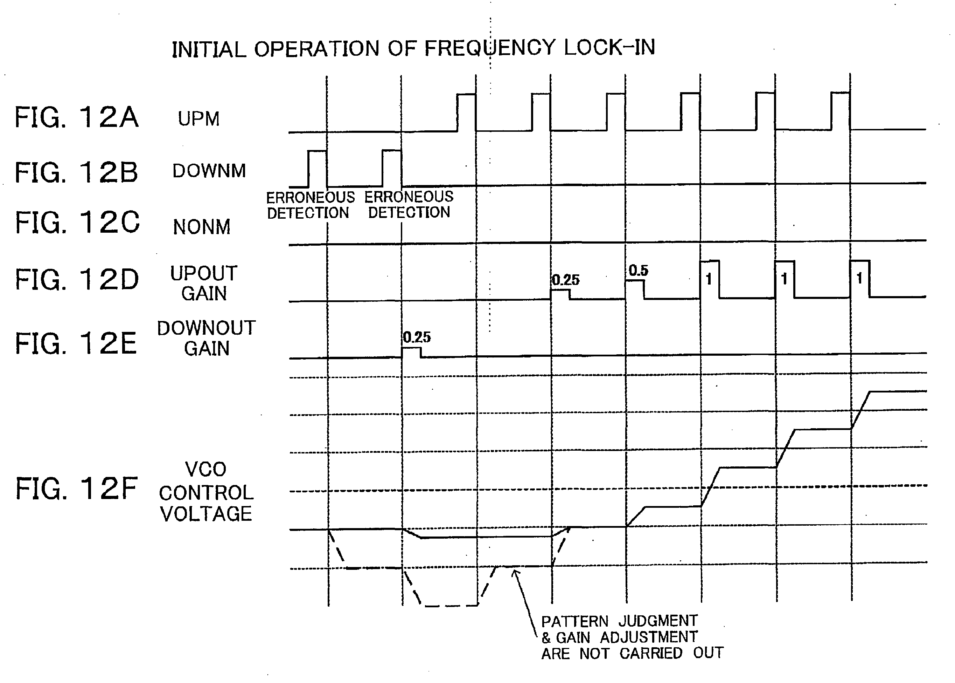

FIG. 12A to FIG. 12F are timing charts showing an example of the operation of the initial stage of the lock-in of the pattern detection and gain adjustment circuit 28 based on the logic of FIG. 11.
At the time of start of the lock-in, the past sequence can not be referred to, therefore feedback with respect to the first UPM or DOWNM signal is made zero.
Thereafter, when the same signal is continuously input, the feedback gain sequentially increases as 0.25, 0.5, and 1.0.

In the case of the example of FIG. 12A to FIG. 12F, the case were the erroneous detection occurred in the initial stage is assumed, but the fluctuation of the control voltage due to erroneous detection can be suppressed to 1/8 in comparison with the case where such gain adjustment is not carried out. In actuality, when frequency error is enlarged due to erroneous detection, as already shown, the detection gain is lowered, therefore it is important to suppress the influence by such erroneous detection.

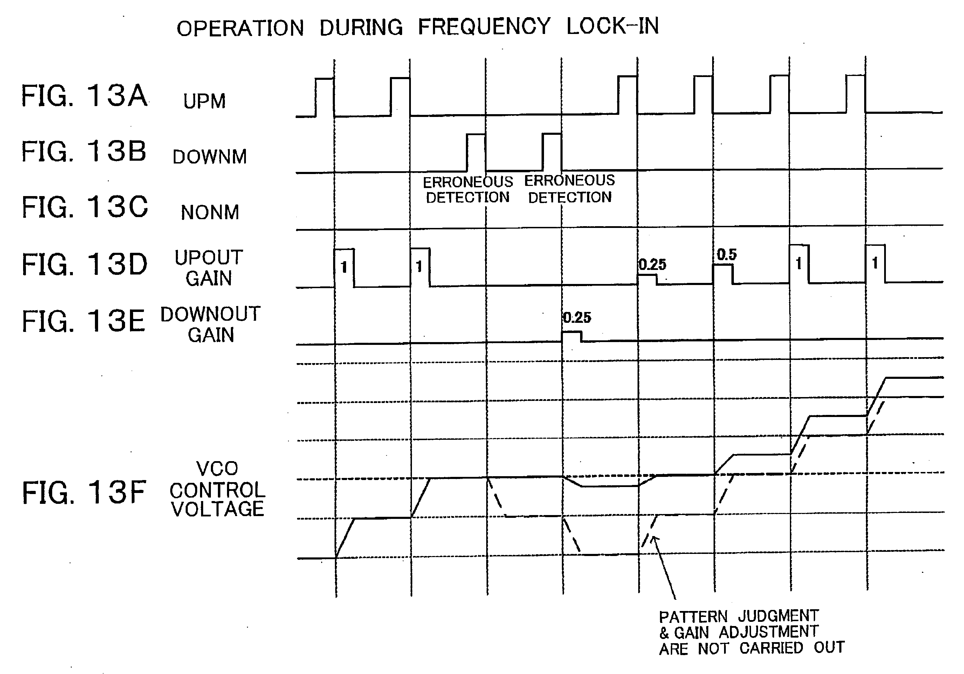

FIG. 13A to FIG. 13F are timing charts showing an example of the operation in the middle of lock-in of the pattern detection and gain adjustment circuit 28 based on the logic of FIG. 11.
When frequency error in the reverse direction is detected due to erroneous detection in the middle of the lock-in, the gain is once made 0. Thereafter, when the same signal continues, the feedback gain is sequentially increased.
In the case of the example of FIG. 13A to FIG. 13F, the frequency fluctuation due to the erroneous detection is suppressed to 1/8 in comparison with the case where such gain adjustment is not carried out.

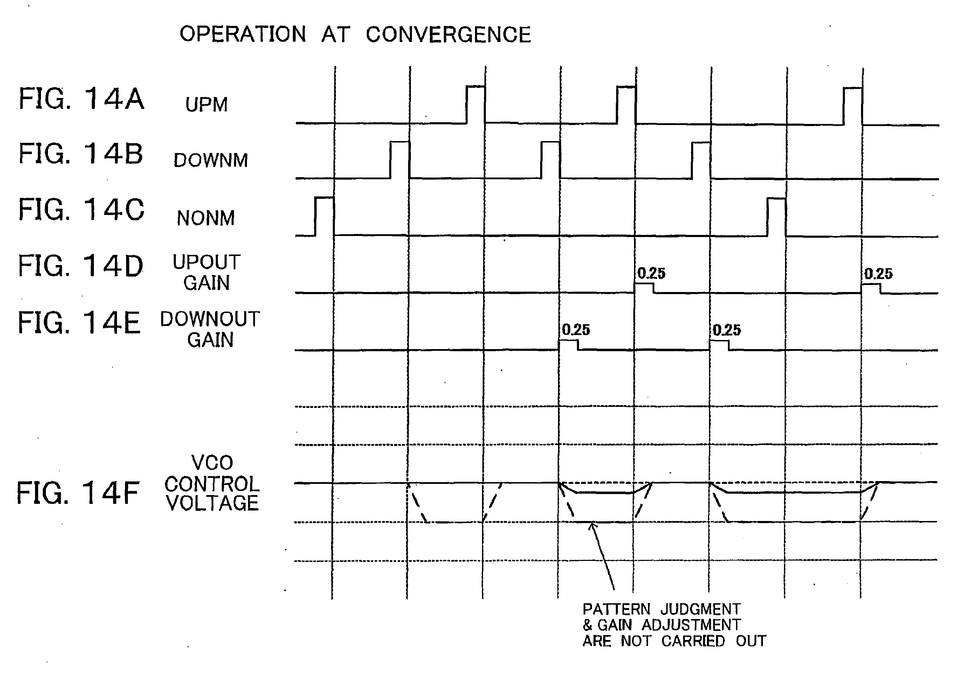

FIG. 14A to FIG. 14F are timing charts showing an example of the operation at the time of the convergence of the pattern detection and gain adjustment circuit 28 based on the logic of FIG. 11.
At the time of the convergence, the difference of integration results of the up signal UP and the down signal DOWN becomes small, and probabilities of appearance of signals UPM and DOWNM become almost the same.
Further, the probability of appearance of the signal NONM becomes high.
In the case of the example of FIG. 14A to FIG. 14F, the detection result does not continue, therefore the gain does not increase, and the frequency fluctuation can be suppressed to 1/4 to 1/8 in comparison with the case where such gain adjustment is not carried out.

Note that, this logic need not be employed as the gain adjustment method using patterns. The monitored pattern length, variation of the patterns, variable range of the gain, a resolution, etc. may be changed.
By these functions, for erroneous detection in the middle of the lock-in, the gain is automatically lowered, and the fluctuation of the VCO frequency due to the erroneous detection can be suppressed.
Further, when the frequency lock-in is converged, it is possible to automatically lower the average feedback gain and suppress frequency fluctuation due to the erroneous detection.

Further, as the gain adjustment method in the present embodiment, since high speed gain switching is possible, a method of changing the switching pulse width of the charge pump 29 was used, but another method may be used so far as the gain can be adjusted. For example, the current value of a current source may be switched.

Next, the operation of the circuit of FIG. 1 will be explained.

The reproduction signal output from the optical head 12 and amplified at the pre-amplifier 13 is adjusted in amplitude in the AGC circuit 14 and input to the analog equalizer circuit 15.
The reproduction signal equalized by the analog equalizer 15 and eliminated high frequency noise is input to the ADC 16 and the zero cross comparator 24.

At this time, the PLL circuit 40 must make the sampling phase of the ADC 16 match with the correct state, but when the deviation between the input signal frequency and the clock frequency is large (where it exceeds approximately 3%), phase lock-in by the phase detector is difficult, therefore the frequency deviation is first pulled in by the frequency loop.

The output of the zero cross comparator 24 is input to the frequency comparator 25 of the PLL circuit 40 and used for the detection of the direction (UP or DONW) of the frequency error.
The output of this up signal UP or the down signal DOWN is further integrated at the integration circuit 26 (integrators 261, 262) and then compared at the comparator 27 and output as the three signals of UPM, DOWNM, and NONM to the pattern detection and gain adjustment circuit 28 in accordance with the set threshold value.
The pattern detection and gain adjustment circuit 28 outputs the signal UPOUT or DOWNOUT or outputs nothing from the sequence of these three signals or changes the width of the output pulse in accordance with the pattern.

The output of the pattern detection and gain adjustment circuit 28 is converted to current at the charge pump circuit 29 for the frequency loop and integrated at the loop filter 30.
The oscillation frequency of the VCO 23 is controlled by an output control signal S30 of the loop filter 30 and made to match with the frequency of the input data signal in the operation.
The VCO 23 has a three-stage ring configuration. The outputs from the stages become the three phase clocks CLKA, CLKB, and CLKC dividing one cycle of CLK to three. These three phase clocks CLKA, CLKB, and CLKC are input to the frequency comparator 25 and compared with the zero cross signal ZC output from the zero cross comparator 24 to thereby perform the frequency detection.

The above description related to the operation in the frequency mode. When the input data signal and the oscillation frequency of the VCO 23 substantially coincide by the operation of the frequency loop, the PLL circuit 40 switches to the phase lock mode.

The output of the ADC 16 is input to the phase comparison circuit 22 of the PLL circuit 40, the phase error data S22 thereof is integrated at the loop filter 30, the VCO 23 is controlled, and the sampling phases of the ADC 16 are made to match.
Further, the output of the ADC 16 is input to the FIR filter 17, further equalized with a high precision, then input to the viterbi decoder 18, decoded and corrected for error, then output as the NRZ data.

As explained above, according to the present embodiment, provision is made of the frequency comparator 25 for fetching the zero cross signal ZC from the zero cross comparator 24 in synchronization with the three phase clocks CLKA, CLKB, an CLKC by the VCO 23 and thereafter observing from which phase to which phase the edge of the zero cross of the input data signal changed in synchronization with for example the first phase clock CLKA to thereby to detect whether the frequency is high or low and output the up signal UP or the down signal DOWN, the integration circuit 26 for integrating the up signal UP or the down signal DOWN of the frequency comparator 25 based on the integration setting value set in the register 31, the comparator 27 receiving the up signal UP or the down signal DOWN integrated by the integration circuit 26, judging the direction of the frequency error in accordance with the judgment threshold value set in the register 32, and outputting three signals of UPM, DOWNM, and NONM in accordance with the judgment result, and the pattern detection and gain adjustment circuit 28 for determining whether or not the signal UPOUT or DOWNOUT is to be output or determining the feedback gain from the pattern of the sequence of the three signals UPM, DONWM, and NONM from the comparator 27 and outputting the same to the charge pump circuit 29, therefore the following effects can be obtained.

Namely, in the frequency comparison method using the input data and the multi-phase clocks of the VCO, when the quality of the zero cross edge of the input signal is bad and the erroneous detection of the frequency comparator occurs, the influence thereof can be reduced, and as a result, stable and high speed frequency lock-in becomes possible.
Further, even in a frequency detection method other than the above, for example, a frequency comparison method for directly measuring the zero cross interval of the data, the influence of the erroneous detection is reduced, and stable and high speed frequency lock-in becomes possible.

### INDUSTRIAL CAPABILITY

The PLL circuit and the information reproduction apparatus according to the present invention can reduce the influence of erroneous detection even when erroneous detection of the frequency comparator occurs and can realize stable and high speed frequency lock-in, therefore can be applied to Blu-Ray disc and other optical disc devices.

## Claims

1. A phase locked loop circuit comprising:
an oscillation circuit oscillating with a frequency in accordance with a control signal and outputting a clock having a predetermined frequency;
a phase comparison circuit detecting a phase difference between a clock from the oscillation circuit and an input signal and outputting phase difference data;
a feedback circuit generating the control signal based on the phase difference data of the phase comparison circuit and a feedback signal and supplying the same to the oscillation circuit;
a frequency comparator comparing frequencies of the input signal and the clock of the oscillation circuit and outputting a signal in accordance with a frequency error;
an integration circuit integrating the signal in accordance with the frequency error of the frequency comparator;
a judgment circuit judging a direction of the frequency error from the integration result of the integration circuit; and
a gain adjustment circuit switching a feedback gain of the feedback signal based on the judgment result of the judgment circuit.

2. A phase locked loop circuit as set forth in claim 1, wherein the gain adjustment circuit switches the feedback gain of the feedback signal based on a sequential pattern of judgment results of the judgment circuit.

3. A phase locked loop circuit as set forth in claim 1, wherein an integration constant of the integration circuit is adjustable.

4. A phase locked loop circuit as set forth in claim 1, wherein the judgment circuit performs the judgment based on a predetermined threshold value and, when the judgment result is smaller than the threshold value, outputs a signal for suspending the output of the feedback signal to the gain adjustment circuit.

5. A phase locked loop circuit as set forth in claim 4, wherein the judgment threshold value of the judgment circuit is adjustable.

6. A phase locked loop circuit as set forth in claim 1, wherein the gain adjustment circuit does not output the feedback signal in an initial lock-in state and, when continuously receiving as input the same judgment result, sequentially increases the feedback gain.

7. A phase locked loop circuit as set forth in claim 6, wherein the gain adjustment circuit once makes the feedback gain zero when receiving as input a judgment result of detection of frequency error in a reverse direction due to erroneous detection in the middle of lock-in, then sequentially increases the feedback gain when continuously receiving as input the same judgment result.

8. A phase locked loop circuit comprising:
an oscillation circuit oscillating with a frequency in accordance with a control signal and outputting multi-phase clocks having different phases from each other;
a phase comparison circuit detecting a phase difference between one clock among the multi-phase clocks from the oscillation circuit and an input signal and outputting phase difference data;
a feedback circuit generating the control signal based on the phase difference data of the phase comparison circuit and a feedback signal and supplying the same to the oscillation circuit;
a frequency comparator detecting frequency error between the input signal and the clock from a zero cross edge of the input signal based on a zero cross signal of the input signal and the multi-phase clocks of the oscillation circuit and outputting a signal in accordance with the frequency error;
an integration circuit integrating the signal in accordance with the frequency error of the frequency comparator;
a judgment circuit for judging the direction of the frequency error from the integration result of the integration circuit; and
a gain adjustment circuit for switching the feedback gain of the feedback signal based on the judgment result of the judgment circuit.

9. A phase locked loop circuit as set forth in claim 8, wherein the gain adjustment circuit switches the feedback gain of the feedback signal based on a sequential pattern of judgment results of the judgment circuit.

10. A phase locked loop circuit as set forth in claim 8, wherein the frequency comparator fetches the zero cross signal of the input signal based on the multi-phase clocks of the oscillation circuit and observes from which phase to which phase the edge of the zero cross of the input data signal changed in synchronization with the one clock among the multi-phase clocks to thereby detect whether the frequency is high or low as the frequency error.

11. A phase locked loop circuit as set forth in claim 10, wherein the frequency comparator suspends the output of the signal in accordance with the frequency error when the change of the edge of the zero cross is detected at a timing when it does not occur in a case of normal operation.

12. A phase locked loop circuit as set forth in claim 8, wherein an integration constant of the integration circuit is adjustable.

13. A phase locked loop circuit as set forth in claim 8, wherein the judgment circuit performs the judgment based on a predetermined threshold value and, when the judgment result is smaller than the threshold value, outputs a signal for suspending the output of the feedback signal to the gain adjustment circuit.

14. A phase locked loop circuit as set forth in claim 13, wherein the judgment threshold value of the judgment circuit is adjustable.

15. A phase locked loop circuit as set forth in claim 14, wherein the gain adjustment circuit does not output the feedback signal in an initial lock-in state and, when continuously receiving as input the same judgment result, sequentially increases the feedback gain.

16. An information reproduction apparatus for sampling a signal read from a recording medium based on a clock to convert it to a digital signal for reproduction, comprising:
a phase locked loop circuit for making a sampling phase by the clock match with a correct state, wherein
the phase locked loop circuit has:
an oscillation circuit oscillating with a frequency in accordance with a control signal and outputting a clock having a predetermined frequency,
a phase comparison circuit detecting a phase difference between a clock from the oscillation circuit and an input signal and outputting phase difference data,
a feedback circuit generating the control signal based on the phase difference data of the phase comparison circuit and a feedback signal and supplying the same to the oscillation circuit,
a frequency comparator comparing frequencies of the input signal and the clock of the oscillation circuit and outputting a signal in accordance with a frequency error,
an integration circuit integrating the signal in accordance with the frequency error of the frequency comparator,
a judgment circuit judging a direction of the frequency error from the integration result of the integration circuit, and
a gain adjustment circuit switching a feedback gain of the feedback signal based on the judgment result of the judgment circuit.

17. An information reproduction apparatus as set forth in claim 16, wherein the gain adjustment circuit switches the feedback gain of the feedback signal based on a sequential pattern of judgment results of the judgment circuit.

18. An information reproduction apparatus as set forth in claim 16, wherein the judgment circuit performs the judgment based on a predetermined threshold value and, when the judgment result is smaller than the threshold value, outputs a signal for suspending the output of the feedback signal to the gain adjustment circuit.

19. An information reproduction apparatus as set forth in claim 16, wherein the gain adjustment circuit does not output the feedback signal in an initial lock-in state and, when continuously receiving as input the same judgment result, sequentially increases the feedback gain.

20. An information reproduction apparatus as set forth in claim 19, wherein the gain adjustment circuit once makes the feedback gain zero when receiving as input a judgment result of detection of frequency error in a reverse direction due to erroneous detection in the middle of lock-in, then sequentially increases the feedback gain when continuously receiving as input the same judgment result.

21. An information reproduction circuit for sampling a sine wave state signal read from a recording medium based on clocks to convert it to a digital signal for reproduction, comprising:
a phase locked loop circuit for making a sampling phase from the clock match with a correct state, wherein
the phase locked loop circuit has
an oscillation circuit oscillating with a frequency in accordance with a control signal and outputting multi-phase clocks having different phases from each other,
a phase comparison circuit detecting a phase difference between one clock among the multi-phase clocks from the oscillation circuit and an input signal and outputting phase difference data,
a feedback circuit generating the control signal based on the phase difference data of the phase comparison circuit and a feedback signal and supplying the same to the oscillation circuit,
a frequency comparator detecting a frequency error between the input clock and the clock from a zero cross edge of the input signal based on a zero cross signal of the input signal and the multi-phase clocks of the oscillation circuit and outputting a signal in accordance with the frequency error,
an integration circuit integrating the signal in accordance with the frequency error of the frequency comparator,
a judgment circuit judging the direction of the frequency error from the integration result of the integration circuit, and
a gain adjustment circuit switching the feedback gain of the feedback signal based on the judgment result of the judgment circuit.

22. An information reproduction apparatus as set forth in claim 21, wherein the gain adjustment circuit switches the feedback gain of the feedback signal based on a sequential pattern of judgment results of the judgment circuit.

23. A phase locked loop circuit as set forth in claim 21, wherein the frequency comparator fetches the zero cross signal of the input signal based on the multi-phase clocks of the oscillation circuit and observes from which phase to which phase the edge of the zero cross of the input data signal changed in synchronization with the one clock among the multi-phase clocks to thereby detect whether the frequency is high or low as the frequency error.

24. A phase locked loop circuit as set forth in claim 23, wherein the frequency comparator suspends the output of the signal in accordance with the frequency error when the change of the edge of the zero cross is detected at a timing when it does not occur in a case of normal operation.

25. An information reproduction apparatus as set forth in claim 21, wherein the judgment circuit performs the judgment based on a predetermined threshold value and, when the judgment result is smaller than the threshold value, outputs a signal for suspending the output of the feedback signal to the gain adjustment circuit.

26. An information reproduction apparatus as set forth in claim 25, wherein the gain adjustment circuit does not output the feedback signal in an initial lock-in state and, when continuously receiving as input the same judgment result, sequentially increases the feedback gain.
